# EUROPÄISCHE PATENTANMELDUNG

(11) **EP 1 107 453 A2**
(43) Veröffentlichungstag der Anmeldung: **13.06.2001**
(21) Anmeldenummer: 00126245.0
(22) Anmeldetag: 01.12.2000
(51) Int. Cl.: H03H 17/02

(54) **Verfahren zur Integration eines elektrischen Signals mittels Tiefpassfilterung**

(30) Priorität: 11.12.1999 DE 19959822
(71) Anmelder: DaimlerChrysler AG, 70567 Stuttgart (DE)
(72) Erfinder: Larice, Markus, 85053 Ingolstadt (DE)
(74) Vertreter: Kolb, Georg

(57) **Zusammenfassung**

Es wird ein Verfahren zur Integration eines elektrischen Signals mittels Tiefpaßfilterung vorgestellt, bei dem parallel zu einem auf den zu erfassenden Meßzeitbereich ausgerichteten Langzeitintegrator-Tiefpaß ein zweiter Tiefpaß vorgesehen ist, dessen Grenzfrequenz höher ist als die des Langzeitintegrators, der jedoch nur über ein gegenüber dem Meßzeitbereich kurzes Zeitfenster aktiv ist und nachfolgend rückgesetzt wird. Zur Kurzzeitintegration ist diesem zweiten Tiefpaß zudem ein Summierer nachgeschaltet, der die Integralwerte mehrerer aufeinanderfolgender Zeitfenster addiert. Die Kurzzeitintegration weist dabei eine bessere Auflösung des Integralwerts auf und ermöglicht so eine genauere Vorgabe von Schwellwerten zum Vergleich des Integralwerts mit diesen bzw. eine exaktere Bestimmung des Zeitpunkts der Übereinstimmung mit dem Schwellwert. Die höhere Offsetfehler-Empfindlichkeit der Kurzzeitintegration hat keine Auswirkung auf das Meßergebnis, da die Kurzzeitintegration nur bei Überschreitung einer vorgegebene Aktivierungsschwelle am Langzeitintegrator aktiviert und bei Erreichen eines Abbruchkriteriums wieder zurückgesetzt wird.

Das vorliegende Verfahren kann grundsätzlich auf analoge als auch digitale Filter angewendet und in ein Signalverarbeitungsprogramm umgesetzt werden. Insbesondere ist eine Anwendung für die Integration von Beschleunigungs- oder Drehgeschwindigkeitssignalen zur Entscheidung über die Auslösung von Insassenschutzeinrichtungen geplant.

## Beschreibung

Die Erfindung betrifft ein Verfahren zur Integration eines elektrischen Signals mittels Tiefpaßfilterung.

Die Integrationswirkung eines Tiefpasses für elektrische Signale eines bestimmten Frequenzbereichs ist allgemein bekannt und bspw. bei Tietze/Schenk: Halbleiter-Schaltungstechnik, Springer-Verlag, 10. Aufl. 1993, S. 12 zu entnehmen. Darüber hinaus ist auch der Einsatz digitaler Tiefpaßfilter auf entsprechend A/D-gewandelte elektrische Signale bekannt und ebenfalls bei Tietze/Schenk auf S. 391 ff. beschrieben, wobei digitale Filter die insbesondere bei äußerst niederfrequenten Signalen deutlich einfacher herstellbar sind als analoge Filter.

Die Dimensionierung solcher Filter für Integrationsaufgaben ergibt sich dabei bekanntermaßen aus der Amplitude und Frequenz des zu integrierenden Signals sowie dem geforderten Meßzeitbereich.

Die zu wählende Grenzfrequenz des Tiefpasses beeinflußt dabei die Dämpfung des Signals und über diese Größe die Zeitdauer, in der ein bestimmtes Signal noch annähernd linear integriert wird. Mit zunehmender Sättigung tritt ein nicht mehr vernachlässigbar nichtlineares Verhalten auf. Je niedriger die Grenzfrequenz des Tiefpasses ist, desto länger wird die mögliche Integrationszeitdauer.

Zudem treten bei realen Signalen Gleichanteile bzw. andere entsprechend niederfrequente Störungen auf, insbesondere die bei Sensoren oft unvermeidbaren Offset-Drift. Diese Anteile im Signal werden zwar üblicherweise durch entsprechende Hochpaßvorfilter bzw. äquivalente Offset-Kompensationsschaltungen stark gedämpft, jedoch oft nicht völlig eliminiert und führen zu einer Abweichung, die bei einer langen aktiven Betriebsdauer des Filters sich dauernd addiert. Bei digitalen Filtern addieren sich zudem noch die Rundungsfehler auf. Je niedriger die Grenzfrequenz des Tiefpasses ist, desto geringer sind die Auswirkungen solcher störender Anteile.

Problematisch ist, wenn ein recht großer möglicher Frequenzbereich von Signalen erfaßt werden muß. Soll der Tiefpaß auch für niedrige Signalfrequenzen noch ausreichend lange eine Integrationsfähigkeit aufweisen, erfordert dies eine entsprechend niedrige Grenzfrequenz des Tiefpasses. Die niedrige Grenzfrequenz bewirkt andererseits, daß für Signale mit hohen Frequenzen die Dämpfung sehr stark und damit die Auflösung der Integration sehr schwach ist.

Die Integration elektrischer Signale mittels einem Tiefpaß wird beispielsweise im Bereich des Insassenschutzes von Kraftfahrzeugen zur Ermittlung der Geschwindigkeitsänderung aus den von Sensoren gewonnenen Beschleunigungsverläufen oder des Verdrehwinkels aus der Winkelgeschwindigkeit genutzt, um erforderlichenfalls entsprechende Insassenschutzeinrichtungen zu aktivieren. Wichtig ist dabei immer auch die sogenannten Nicht-Auslösefälle sicher zu erkennen, bei denen also bspw. die Geschwindigkeitsänderung oder Fahrzeugneigung gering ist oder die Signale nur durch Störungen, bspw. Fahrbahnunebenheiten oder Fahrbahnneigung, hervorgerufen werden. In all diesen Fällen ist eine Auslösung nicht erforderlich und insbesondere auch unerwünscht, da die Insassenschutzeinrichtungen in den meisten Fällen teuer und nur einmal aktivbar sind. Zudem wird durch die Auslösung der Insassenschutzeinrichtungen die Reaktionsfähigkeit des Fahrers stark einschränkt - eine zu frühe oder nicht erforderliche Auslösung somit gefährlich. Genaue Integralwerte für sehr unterschiedliche Signalverläufe sind daher gerade auch in diesem Anwendungsbereich besonders wichtig.

Im Anwendungsfall beim Insassenschutz ist das eigentliche Signal oft nur einige Millisekunden oder Sekunden lang, die Integration muß jedoch im Prinzip während der gesamten Fahrt aktiv sein. Selbst geringste Offset-Fehler können daher zu erheblichen Abweichungen führen.

Niedrige Signalfrequenzen ergeben sich im Anwendungsbereich des Insassenschutzes bspw. durch Niedergeschwindigkeitsauffahrunfälle oder eine langsame Annäherung des Fahrzeuges an einen kritischen Kippwinkel in einer Steilwandkurve oder Rampe und müssen daher erfaßt werden. Gerade aber auch besonders schnelle Signalverläufe sind im Anwendungsbereich des Insassenschutzes äußerst wichtig für die Entscheidung über die Auslösung von Insassenschutzeinrichtungen, wie Airbags, Gurtstraffer, Überrollbügel und ähnliche. Eine ungenaue Bestimmung des Integralwertes ist also für sicherheitskritische Anwendungen ebenfalls untragbar, zumal bereits zu einem verhältnismäßig frühen Zeitpunkt des Gesamtsignalverlaufs eine Entscheidung über eine Auslösung dieser Insassenschutzeinrichtungen erforderlich ist, um die insassenschützende Wirkung voll zu erreichen.

Aufgabe der Erfindung ist es daher, ein Verfahren zur Integration eines elektrischen Signals mittels Tiefpaßfilterung anzugeben, bei dem für einen großen Frequenz- und Meßzeitbereich des Signals eine störungsfreie, annähernd lineare und ausreichend fein aufgelöste Integration des elektrischen Signals erfolgt.

Diese Aufgabe wird durch die Merkmale des Anspruchs 1 gelöst. Vorteilhafte Weiterbildungen sind den Unteransprüchen zu entnehmen.

Grundlegend dabei ist, daß parallel zu dem einem ersten Tiefpaß, im folgenden auch Langzeitintegrator genannt, ein zweiter Tiefpaß mit einer höheren Grenzfrequenz verwendet wird. Entscheidend ist aber darüber hinaus, daß dieser zweite Tiefpaß im Gegensatz zum Langzeitintegrator nur über gegenüber dem Meßzeitbereich kurzes Zeitfenster aktiv ist. Er wird daher nachfolgend auch als Kurzzeitintegrator bezeichnet. Bei längerer Integration würde der Integralwert im Kurzzeitintegrator bei niederfrequenten Signalen oder Signalen hoher Amplitude in den nichtlinearen Bereich ansteigen oder gar die Sättigung des Filters erreichen.

Im Kurzzeitintegrator wird daher für ein Zeitfenster jeweils nur die jeweilige Änderung des Signals erfaßt und der entsprechende Integralwert nachfolgend als Kurzzeitintegralwert bezeichnet. Der Kurzzeitintegrator erfaßt dabei jedoch auch noch Signale höherer Frequenz deutlich feiner aufgelöst als der Langzeitintegrator.

Um dennoch mit dem Kurzzeitintegrator den Meßzeitbereich abdecken zu können, werden die Integralwerte des Kurzzeitintegrators am Ende des Zeitfensters an einen Summierer übergeben und der Kurzzeitintegrator auf Null zurückgesetzt, d.h. bei analoger Schaltungsrealisierung mit Masse verbunden. Im Summierer werden diese Kurzzeitintegralwerte mehrerer Zeitfenster dann zum eigentlichen Integralwert summiert, gegebenenfalls über den gesamten Meßzeitbereich.

Andererseits ist der Kurzzeitintegrator jedoch anfälliger für niederfrequente Störungen, die bei der digitalen Ausgestaltung der Filter auch durch die Rundungsfehler ergänzt werden und so zu einem Offset-Fehler führen.

Würde der Kurzzeitintegrator immer aktiv dem Signal folgen, würde sich nach endlich langer Zeit dieser Offset-Fehler zu einem nicht mehr vernachlässigbaren Wert addiert haben und den Integralwert zunehmend verfälschen.

Aus diesem Grund sieht das Verfahren vor, daß die Kurzzeitintegration nur dann aktiviert wird, wenn das Ausgangssignal am ersten Tiefpaß, also dem Langzeitintegrator, eine vorgegebene Aktivierungsschwelle überschreitet. Der Langzeitintegrator ist demgegenüber deutlich weniger anfällig für diese Störungen.

Diese Kurzzeitintegration einschließlich der Summation wird wieder rückgesetzt, wenn ein Abschaltkriterium erreicht wird, insbesondere das Ausgangssignal am ersten Tiefpaß eine Abschaltschwelle unterschreitet. Dabei wird ausgenutzt, daß der Integralwert am Langzeitintegrator bei abklingender Signalamplitude auch wieder zurückgeht, was für eine Reihe von Anwendungsfällen, insbesondere im Bereich Insassenschutz gewünscht ist. Durch die Rücksetzung der stärker Offset-belasteten Kurzzeitintegration wird eine Neukalibirierung dieser ermöglicht, während der Langzeitintegrator durch sich durch die Rückführung kalibriert. Grundsätzlich sind auch andere Abschaltkriterien denkbar, bspw. das Ende des Meßzeitbereichs, die Unterschreitung einer Mindest-Signalamplitude des Eingangssignals oder ähnliches.

Beim Start der Kurzzeitintegration am zweiten Tiefpaß wird vorzugsweise der am ersten Tiefpaß bis zum Überschreiten der Aktivierungsschwelle erreichte Integralwert berücksichtigt, indem am Kurzzeitintegrator oder am Summierer dazu ein entsprechender Anfangswert gesetzt wird. Da der Kurzzeitintegrator deutlich empfindlicher auf das Signal reagiert als der Langzeitintegrator, wirkt sich der bis dahin erreichte Integralwert bei dem Kurzzeitintegrator stärker aus. Die Aktivierungsschwelle sollte daher am zweiten Tiefpaß berücksichtigt werden. Dieser muß dazu entsprechend der unterschiedlichen Dämpfung mit einem Faktor multipliziert sein, um den Anfangswert zu ergeben.

Vorzugsweise erfolgt ein Plausibilitätstest zwischen dem Integralwert am Summierer und dem am ersten Tiefpaß erfaßten Langzeitintegralwert durch Vergleich beider miteinander, wobei zumindest einer der beiden Integralwerte, wie beim Anfangswert auch, mit einem Faktor gewichtet wird, der die unterschiedliche Dämpfung der beiden Tiefpässe ausgleicht.

Bevorzugt erfolgt für den ersten und zweiten Tiefpaß eine Offset-Kompensation, indem das Signal auch einem Offset-Kompensations-Tiefpaß mit einer Grenzfrequenz noch deutlich unterhalb der Grenzfrequenzen beider Tiefpässe zugeführt und das Ausgangssignal dieses Offset-Kompensations-Tiefpasses von den Eingangs- oder Ausgangssignalen der beiden Tiefpässe abgezogen wird.

Besonders bevorzugt ist dabei, die Offset-Kompensation zumindest für den Kurzzeitintegrator bereits an dessen Eingang durchzuführen, da sonst der Offset zu einem zu starken Anstieg des Integralwerts im Kurzzeitintegrator führt.

Die Grenzfrequenzen der Tiefpässe können ausgehend von einer unteren und einer oberen Nutzsignalgrenzfrequenz des elektrischen Signals bestimmt werden.

Die Grenzfrequenz des Offset-Kompensations-Tiefpasses liegt vorzugsweise zumindest unterhalb der unteren Nutzsignalgrenzfrequenz, vorzugsweise so niedrig, daß die maximal zu erwartenden Drifterscheinungen noch möglichst stark gedämpft werden. Die maximale Driftgeschwindigkeit kann aus den Datenblättern der verwendeten Sensoren entnommen werden. Die Driftgeschwindigkeit bestimmt andererseits auch die untere Nutzsignalgrenzfrequenz.

Die Grenzfrequenz des Langzeitintegrators liegt vorzugsweise soweit unterhalb der unteren Nutzsignalgrenzfrequenz, daß im Langzeitintegrator für diese untere Nutzsignalgrenzfrequenz über den Meßzeitbereich noch eine annähernd lineare Integration möglich ist.

Die Grenzfrequenz des Kurzzeitintegrators dagegen liegt vorzugsweise soweit unterhalb der oberen Nutzsignalgrenzfrequenz, daß im Kurzzeitintegrator für diese obere Nutzsignalgrenzfrequenz über das Zeitfenster eine annähernd lineare Integration möglich ist.

Die Erfindung soll nachfolgend anhand von Ausführungsbeispielen und Figuren näher erläutert werden. Kurze Beschreibung der Figuren:
- Figur 1: Blockaufbau einer Anordnung zur Durchführung des Verfahrens
- Figur 2: Ablauf der Integration im ersten und zweiten Filter mit Skalierung der Ausgangssignale der Filter auf das mathematisch exakte Integral
- Figur 3: Ausgangssignale mehrerer Tiefpässe auf einen Rechteckimpuls im Vergleich
- Figur 4: Ausgangssignal eines Tiefpaß auf ein Rechtecksignal mit unterschiedlichen Faktoren gewichtet im Vergleich zum mathematisch exakten Integral
- Figur 5: Ausgangssignal eines Tiefpaß auf ein reales Meßsignal mit unterschiedlichen Faktoren gewichtet im Vergleich zum mathematisch exakten Integral
- Figur 6: Ablauf der Integration im ersten und zweiten Filter für ein Sensorsignal, welches zur Auslösung führt
- Figur 7: Ablauf der Integration für einen Nicht-Auslösefall
- Figur 8: Amplitudenfrequenzgang der einzelnen Filter im Vergleich

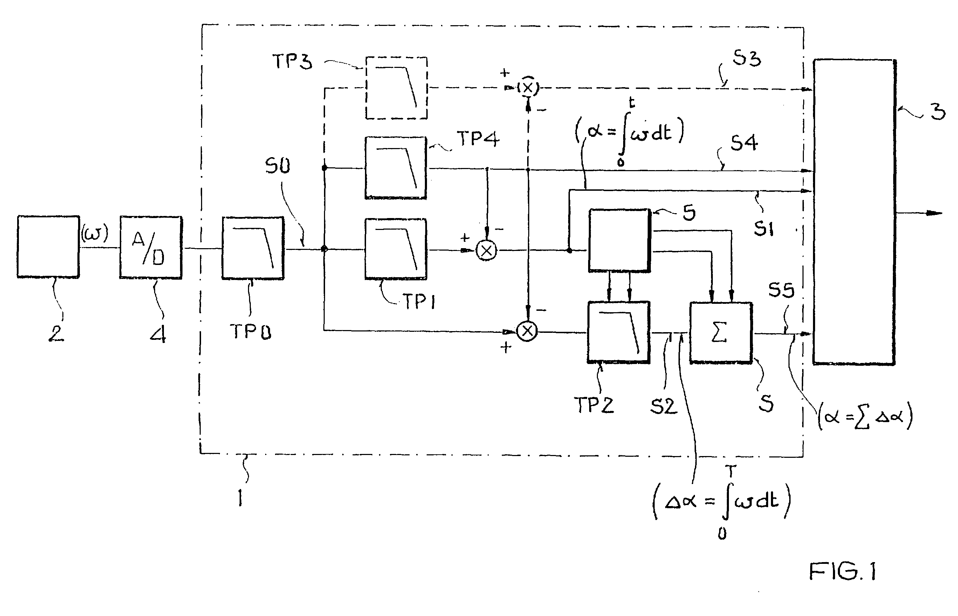

Die Figur 1 zeigt in einem Blockaufbau eine mögliche Anordnung zur Durchführung des Verfahrens. Die Filterung und Integration erfolgt dabei in diesem Ausführungsbeispiel mittels digitaler Filter, wobei grundsätzlich auch analoge Ausgestaltung der Filter denkbar ist, sofern die entsprechend den jeweiligen Signal - und Meßbedingungen zu wählenden Grenzfrequenzen dies zulassen. Der Blockaufbau gezeigte Blockaufbau ermöglicht es, die funktionalen Abläufe zu erfassen, die für digitale Filter auch als Software in einem Numerik-Prozessor umgesetzt werden können.

Das Verfahren wird anhand der Überschlag-Sensierung (roll-over) durch Integration von Winkelgeschwindigkeitssignalen zu einem Verdrehwinkel beschrieben, wobei das Verfahren und die damit verbundenen grundlegenden Überlegungen auch auf andere Anwendungsgebiete übertragbar sind. Im Insassenschutzbereich ist es insbesondere auch für die Integration von Beschleunigungssignalen grundsätzlich geeignet. Es bedarf jeweils einer auf die jeweiligen Signalverhältnisse und Betriebsaufgaben angepaßten Bestimmung geeigneter Grenzfrequenzen der einzelnen Filter und deren Optimierung auf die speziellen Erfordernisse.

Die Anordnung in Figur 1 besteht aus einer Filter- und Integrationseinheit 1, die ein durch einen A/D-Wandler 4 digitalisiertes Meßsignal des Sensors 2 erhält. Der Sensor 2 erzeugt in diesem Anwendungsfall ein Drehgeschwindigkeitssignal. Der Filter- und Integrationseinheit 1 nachgeschaltet ist eine Auswerteeinheit 3, die der weiteren Auswertung, insbesondere noch näher beschriebener Plausibilitätstests und gegebenenfalls der Erzeugung geeigneter Auslösesignale dient.

Das Eingangssignal ω des Sensors 2 wird im A/D-Wandler 4 digitalisiert und nachfolgend durch einen Tiefpaß TPO geglättet, welcher hochfrequente Störungen oberhalb des Nutzsignalfrequenzbereichs herausfiltert. Das so gewonnene Ausgangssignal s0 wird dem Tiefpaß TP1 zugeführt, welches als Langzeitintegrator mit seiner Grenzfrequenz so dimensioniert ist, daß der für den Nutzsignalfrequenzbereich eine annähernd lineare Integration über den gesamten Meßbereich erlaubt. Parallel dazu erhält ein Offset-Kompensations-Tiefpaß TP4 das Signal sO. Dieser Offset-Kompensations-Tiefpaß TP4 spaltet die durch eine Offset-Drift des Sensors bedingte Änderung des Signals s0 ab, welche von den Eingangs- oder Ausgangssignalen der anderen Tiefpässe abgezogen wird.

Bereits Offset-kompensiert erhält der zweite Tiefpaß TP2 das Signal sO. Der Tiefpaß TP2 ist als Kurzzeitintegrator ausgebildet. Dem Kurzzeitintegrator TP2 nachgeschaltet ist ein Summierer S, welcher die in dem Kurzzeitintegrator TP2 auftretenden Kurzzeitintegralwerte (Δα) über mehrere Zeitfenster hinweg erfaßt und zu einem Integralwert (α = Σ Δα | über alle T) addiert.

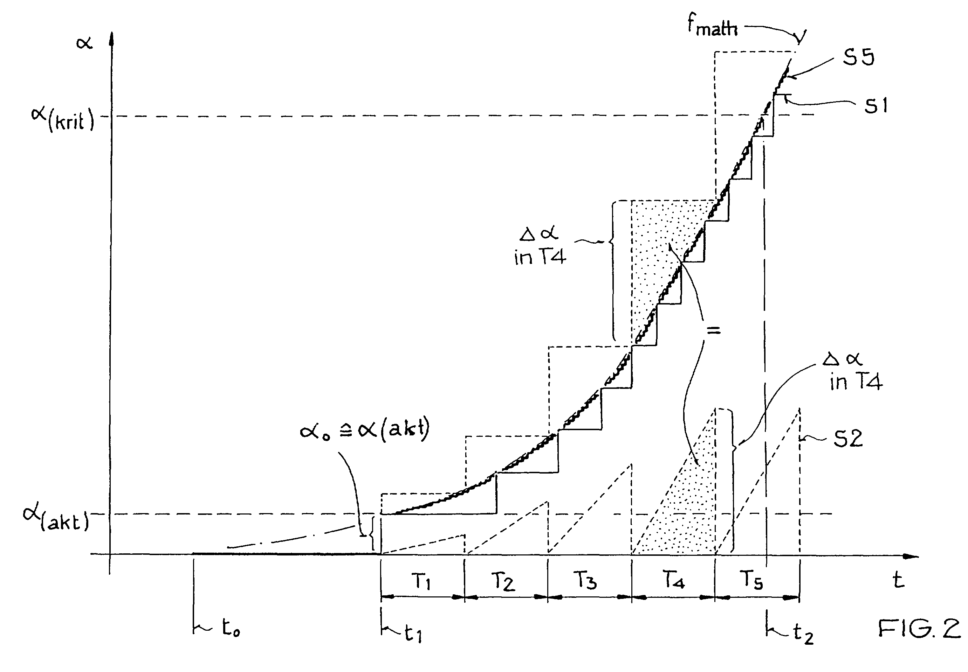

Kurzzeitintegrator TP2 und Summierer S werden dabei durch eine Steuereinheit 5 angesteuert. Die Steuereinheit 5 überwacht einerseits das Ausgangssignal s1 des Langzeitintegrators TP1 und erzeugt beim Erreichen einer Aktivierungsschwelle ein Startsignal an den Kurzzeitintegrator TP2 und an einen nachgeschalteten Summierer S. Zuvor sind Kurzzeitintegrator TP2 und Summierer S auf ihren jeweiligen Ausgangswert gesetzt. Die Steuereinheit 5 regelt auch die Rücksetzung und den Neustart des Kurzzeitintegrator TP2 nach Ablauf eines vorgegebenen Zeitfensters. Das Zeitfenster T ist kurz gegenüber dem Meßzeitbereich, wobei die Dimensionierung nachfolgend noch näher beschrieben wird (siehe dazu Fig. 2). Zudem wird beim Auftreten eines Abschaltkriteriums auch ein Abschaltsignal an den Kurzzeitintegrator TP2 und den nachgeschalteten Summierer S gesendet und diese auf ihre Anfangswerte zurückgesetzt.

Ergänzend ist in Figur 1 noch ein weiterer parallel das Signal s0 erfassender Tiefpaß TP3 angedeutet, dessen Grenzfrequenz über der des Kurzzeitintegrators TP2 liegt. Dieser TP3 erzeugt ein weiteres Integralsignal s3 für andere, insbesondere für noch frühzeitiger auszulösende Sicherheitsfunktionen, bspw. Gurtstrammer, wobei dieses Signal s3 ebenfalls mittels des Signals s4 näherungsweise Offset-kompensiert wird.

Die nachgeschaltete Auswertung 3 führt eine Reihe von Prüfungen durch. Dabei erfolgt vorzugsweise zumindest ein Vergleich zwischen den Integralwerten des Summierers, also dem Signal s5, und des ersten Tiefpasses TP1, also Signal s1, die auf zumindest näherungsweise Übereinstimmung miteinander verglichen werden, wobei zumindest einer der beiden Integralwerte durch einen Faktor gewichtet wird, um die unterschiedliche Dämpfung des Eingangssignals an den beiden Tiefpässen TP1 und TP2 auszugleichen. Zu berücksichtigen ist dabei die deutlich grobere Auflösung von s1, so daß s1 nur näherungsweise s5 entsprechen kann und muß. Die Auswertung 3 kann zudem die anderen zur Verfügung stehenden Signale s3 und s4 bei der Entscheidung über die Auslösung einzelner Insassenschutzeinrichtungen mit berücksichtigen.

Würde im Extremfall ein äußerst langsames Signal die Integrationsfähigkeit des Kurzzeitintegrators TP2 übersteigen, also bspw. es im Summierer S zu einem Überlauf kommen, so kann die Auswertung 3 entscheiden, auch nur auf Basis des Signals sl des Langzeitintegrators TP1 über die Auslösung von Insassenschutzeinrichtungen zu entscheiden. Es kann also das jeweils plausiblere Signal zur Auslöseentscheidung herangezogen werden.

Die Dimensionierung der Grenzfrequenzen der Tiefpässe TP1 und TP2 und des Zeitfensters T soll nachfolgend erläutert werden.

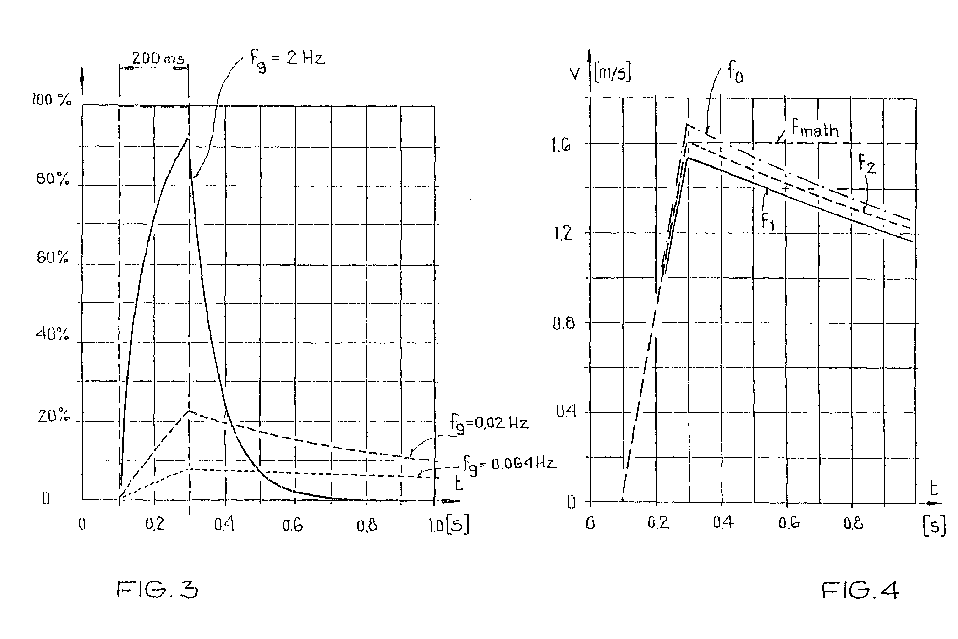

Betrachtet man zunächst in Figur 3 die Sprungantwort auf einen Rechteckimpuls von 200 msec Länge für drei Tiefpaßfilter mit den Grenzfrequenzen 2 Hz, 0,02 Hz und 0,064 Hz, so wird deutlich, daß mit abnehmender Grenzfrequenz der Verlauf immer flacher, jedoch auch linearer wird. Je niedriger die Grenzfrequenz gewählt wird, desto länger wird das Zeitintervall, in dem das gefilterte Signal nur geringfügig vom mathematisch exakten Integralwert abweicht. Ab einer gewissen Grenzfrequenz unterscheiden sich die Ausgangssignale annähernd nur noch um einen festen Faktor, wie später noch erläutert wird.

Soll ein Tiefpaß, wie im Beispiel TP1 als Langzeitintegrator ausgebildet werden und das Signal über einen langen Meßzeitbereich erfassen, wird also eine niedrige Grenzfrequenz gewählt. Die Auflösung des Integralwerts am Ausgangssignal ist dementsprechend gering.

Eine Integration über den gesamten Signalzeitbereich des Rechteckimpulses von 200 msec an einem Tiefpaß mit 2 Hz Grenzfrequenz gerät bereits stark in die Sättigung. Für ein gegenüber den 200 msec kurzes Zeitfenster jedoch kann aber auch dementsprechend ein deutlich stärkeres und damit auch besser aufgelöstes Signal erzielt werden. Dies wird für die Kurzzeitintegration an TP2 ausgenutzt.

Für ein Zeitfenster, welches kurz ist gegenüber dem Meßzeitbereich, wird das Signal zu einem Kurzzeitintegralwert addiert. Um nun zu dem Integralwert des Gesamtsignals zu gelangen, wird diese Kurzzeitintegration für weitere Zeitfenster jeweils neu gestartet und die Kurzzeitintegralwerte jeweils im Summierer addiert. (siehe dazu Fig. 2)

Durch die Kopplung von einem gut auflösenden Kurzzeitintegrator TP2 und dem Summierer S kann somit über eine Vielzahl von Zeitfenstern der gewünschte Meßzeitbereich erfaßt werden.

In Figur 3 wird zudem die Rückführungseigenschaft von Tiefpässen deutlich, die im Gegensatz zum mathematischen Integralwert beim Abklingen des Rechteckimpulses auch zu einer, wiederum e-förmigen Rückführung des Ausgangssignals führt. Diese Rückführungseigenschaft ist für eine Reihe von Anwendungen, insbesondere bei wiederholt auftretenden und einzeln auszuwertenden Signalereignissen bei der Langzeitintegration vorteilhaft, denn sie ermöglicht die natürliche und allmähliche Löschung des Integralwerts des vorangegangenen Ereignisses für das nachfolgende.

Gerade bei realen Sensorsignalen im Bereich des Insassenschutzes treten solche Signalverläufe auf. Für die Langzeitintegration wird daher diese Rückführung angewandt.

Bei Tiefpässen mit höheren Grenzfrequenzen ist diese Rückführungseigenschaft eventuell so stark, daß auch zu einem Ereignis zusammengehörende, jedoch durch einen vorübergehenden Abfall unterbrochene Signalbestandteile voneinander getrennt würden, also der Integralwert des ersten Signalbestandteils bereits abfällt, bevor der nachfolgende erfaßt wird.

Die Integration über den Kurzzeitintegrator und Summierer weist hingegen gerade keine Rückführung auf, da zwar bei abfallendem Eingangssignal am Kurzzeitintegrator nur noch äußerst geringe Kurzzeitintegralwerte auftreten, im Summierer aber die vorherigen voll erhalten bleiben.

Da jedoch die Offset-Kompensation über den Tiefpaß TP4 nur über eine endlichen Dämpfung der Offset-Drift verfügt und zudem bei digitalen Filtern Rundungsfehler hinzukommen, würden diese bei einer permanenten Integration am Kurzzeitintegrator TP2 dennoch zu einer nicht vernachlässigbaren Abweichung führen können.

Betrachtet man zudem über den Meßzeitbereich eines Ereignisses hinaus das Signal über eine noch längere Zeit des aktiven Betriebs, so erweist es sich als vorteilhaft, den Kurzzeitintegrator nicht permanent aktiv zu belassen.

Gegenüber dem Meßzeitbereichs eines Unfalls oder Überschlags ist beispielsweise die Dauer einer Fahrt eines Kraftfahrzeugs um ein Vielfaches länger, so daß auch geringste Offset-Fehler bei der feinen Auflösung am Kurzzeitintegrator über eine so lange Betriebszeit zu nicht mehr vernachlässigbaren Abweichungen führen.

Daher wird die Kurzzeitintegration erst dann aktiviert, wenn am Langzeitintegrator TP1 eine Aktivierungsschwelle überschritten wird. Zudem wird die Kurzzeitintegration beim Erreichen eines Abbruchkriteriums abgebrochen und Kurzzeitintegrator TP2 und Summierer S auf ihre Anfangswerte zurückgesetzt.

Wie bereits im Zusammenhang mit Figur 3 erwähnt, liegt im Bereich der annähernd linearen Integration ein fester Umrechnungsfaktor zwischen den Integralwerten zweier Tiefpässe mit unterschiedlicher Grenzfrequenz vor, so daß diese jeweils durch einen Faktor normiert werden können, bspw. auf das mathematisch exakte Integral. Die Amplitude des Eingangssignals spielt dabei keine Rolle, sofern das Zeitfenster nur ausreichend kurz gewählt ist.

Figur 4 zeigt die Integrationswirkung eines Tiefpasses mit einer Grenzfrequenz von 0,064 Hz auf einen 200 msec Rechteckimpuls gewichtet mit mehreren Faktoren im Vergleich zum mathematisch exakten Integral. Das mathematisch exakte Integral ist mit fmath bezeichnet. Demgegenüber weist der Integralwert f0 am Tiefpaß ohne Gewichtung, also mit Faktor =1, eine leichte Überhöhung auf. Geht man von einer linearen Approximation der Tiefpaßkennlinie am Anfangspunkt aus, würde sich ein Faktor von 1/2πfg als theoretisch beste Annäherung von unten für infinitesimal kurze Zeitfenster ergeben, der für f1 gewählt wurde. Da die Zeitfenster T jedoch endliche Länge aufweisen, erweist sich jedoch ein Wert zwischen diesen beiden als der geeignete Faktor, wie in Funktion f2 dargestellt. Überträgt man diesen für ja für einen Rechteckimpuls optimierten Faktor auf reale Meßsignale eines Überrollvorgangs, erweist sich eine nochmalige Anpassung des Faktors als vorteilhaft.

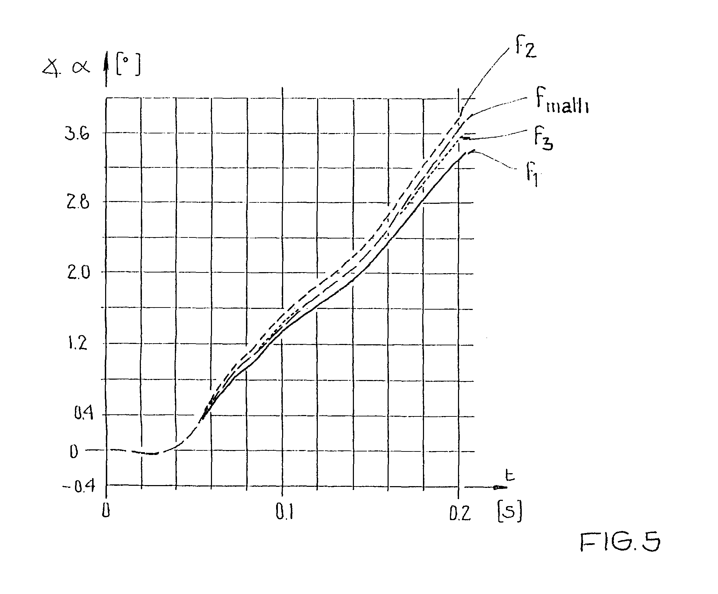

So ist in Figur 5 wieder das mathematisch exakte Integral fmath für dieses reale Signal im Vergleich zu den mit den unterschiedlichen Faktoren gewichteten Tiefpaßantworten dargestellt. f1 zeigt den Verlauf bei Gewichtung mit dem Faktor 1/2πfg, also theoretisch besten Annäherung von unten für kurze Zeitfenster. f2 zeigt den Verlauf bei Gewichtung mit demjenigen Faktor, der für einen Rechteckimpuls mit 200 msec Länge optimal wäre. Durch einen dritten, zwischen diesen beiden liegenden Faktor kann eine noch bessere Annäherung für reale Signale erreicht werden, wie die Funktion f3 verdeutlicht.

Anstelle der Anpassung der Ausgangssignale mittels des jeweiligen Faktors können auch die Vergleichsschwellen entsprechend angepaßt werden.

Die Figur 2 zeigt nun einen möglichen Verlauf der Integralwerte des Lang- und Kurzzeitintegrators (sl für TP1, s2 für TP2 und s5 für das Ausgangssignal am Summierer S) für einen klassischen Auslösefall mit einem immer weiter ansteigenden Neigungswinkel des Fahrzeugs. Das mathematisch exakte Integral fmath ist ergänzend dargestellt. Die Signale wurden dabei entsprechend dem mathematisch exakten Integral skaliert dargestellt.

Dabei wird zunächst die deutlich grobe Auflösung des Signals s1 des Langzeitintegrators TP1 im Verhältnis zu den Signalen s2 und s5 der Kurzzeitintegration am zweiten Tiefpaß TP2 und am Summierer S deutlich.

Bei dem gezeigten Verlauf treten ab dem Zeitpunkt t0 Drehgeschwindigkeitssignale auf, die zunächst nur vom Langzeitintegrator TP1 erfaßt werden, der permanent aktiv ist. Das Signal s1 folgt fmath aufgrund der schwachen Auflösung nur grob.

Erreicht zum Zeitpunkt t1 der Integralwert f1 am Langzeitintegrator TP1 die Aktivierungsschwelle a(akt), bspw. 1 Digit, so wird die Kurzzeitintegration im Kurzzeitintegrator TP2 sowie im Summierer S gestartet, wobei s2 das Ausgangssignal des Kurzzeitintegrators TP2, s5 die Aufsummierung am Summierers S zeigt. Die Kurzzeitintegration beginnt dabei mit einem der Aktiverungsschwelle a(akt) entsprechenden Anfangswert α0, der in dem gezeigten Beispiel im Summierer S voreingestellt ist.

Beide Tiefpässe TP1 und TP2 integrieren nun das Eingangssignal, wobei die Auflösung des Kurzzeitintegrators TP2 erkennbar feiner ist. Der Kurzzeitintegrator TP 2 erfaßt das Eingangssignal dabei jeweils nur über ein Zeitfenster T und wird danach zurückgesetzt und neu gestartet, wie der Verlauf von s2 über mehrere Zeitfenster T1, T2, T3 .... anschaulich zeigt. Für das Zeitfenster T4 ist beispielhaft auf der Kurzzeitintegralwert Δα in T4 hervorgehoben..

Im Summierer S jedoch werden die vom Kurzzeitintegrator TP2 zum Ende eines jeden Zeitfensters T erreichten Kurzzeitintegralwerte abgelegt bzw. zur Summe aller vorangegangenen Kurzzeitintegralwerte addiert. Das Ausgangssignal s5 des Summierers S weist dabei immer die Summe der vorangegangenen Kurzzeitintegralwerte und den am Kurzzeitintegrator TP2 gerade aktuellen Kurzzeitintegralwert auf. Die einzelnen Bestandteile aus dem Signal s2 des zum Integralwert addierten Signals s5 sind dabei jeweils als Anstiegsdreiecke skizzenhaft am Verlauf von s5 angedeutet (siehe bspw. Anstiege für T4 in s2 und s5), wobei diese gegenüber dem Signal s2 einzig aus Gründen der besseren Übersichtlichkeit nach oben geklappt bzw. um 180 Grad gedreht sind.

Wird zum Zeitpunkt t2 von der Kurzzeitintegration (s5) am Ausgang des Summierers S die Auslöseschwelle a(krit) erreicht, so erfolgt ein Auslösebefehl an bestimmte Insassenschutzeinrichtungen. Der Auslösezeitpunkt t2 kann dabei aufgrund der deutlich feineren Auflösung der Kurzzeitintegration präziser bestimmt werden als am Langzeitintegrator TP1, der in diesem Beispiel erst später die Schwelle überschreitet.

Gerade im Bereich des Insassenschutzes treten besonders hohe Genauigkeitsanforderungen auf. Zum einen ist eine exakte Bestimmung der Auslöseschwellen wichtig, da diese möglichst genau auf die technischen Gegebenheiten, bspw. den Kippwinkel eines Fahrzeuges angepaßt werden sollen. Zur Entfaltung der optimalen Schutzwirkung von Insassenschutzeinrichtungen sind zudem die Auslösezeitpunkte ganz entscheidend. Daran wird bereits der besondere Vorteil des Verfahrens deutlich.

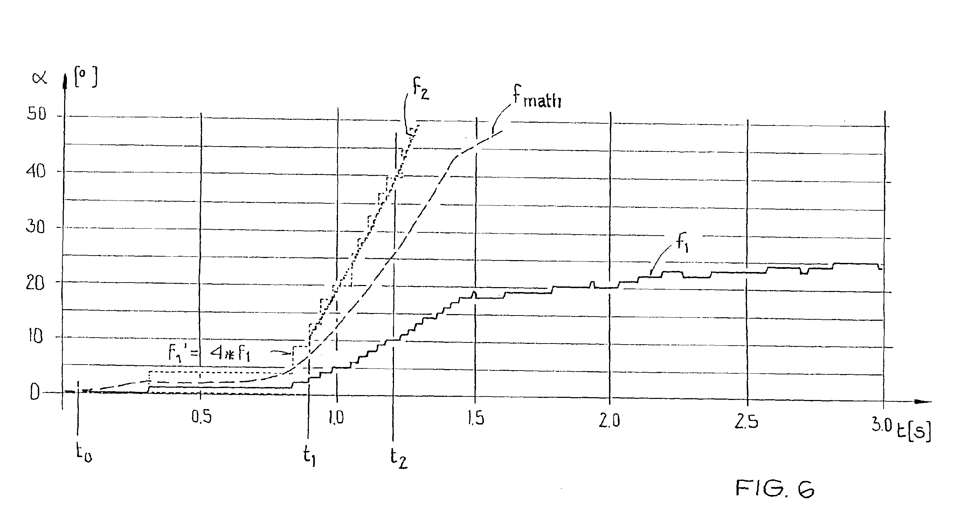

Die Figur 6 zeigt analog den Verlauf der Integralwerte des Lang- und Kurzzeitintegrators (f1 für TP1, f2 für TP2 mit Summierer S) anhand eines realen Meßsignals für einen Auslösefall, wobei diesmal auf eine Skalierung verzichtet und dafür die Auslöseschwellen αfire(f1) und αfire(f2) angepaßt werden. Diese Auslöseschwellen für f1 und f2 sind unterschiedlich groß, entsprechen aber zumindest näherungsweise dem gleichen Winkelwert α.

Der Überschlag erfolgt in dem gezeigten Beispiel mit ca. 1 Sekunde. Sollen noch längere Zeitfenster erfaßt werden, wird sich die Auflösung des Langzeitintegrators TP1 noch weiter verschlechtern und der Vorteil der Ausnutzung des Kurzzeitintegrators TP2 zusammen mit dem Summierer S noch stärker.

Bei dem gezeigten Verlauf in Fig. 6 treten ab dem Zeitpunkt t0 Drehgeschwindikeitssignale auf, die zunächst nur vom Langzeitintegrator TP1 erfaßt werden, der permanent aktiv ist. Erreicht zum Zeitpunkt t1 der Integralwert f1 am Langzeitintegrator TP1 die Aktiverungsschwelle |(akt), bspw. 3 Digit, so wird die Kurzzeitintegration im Kurzzeitintegrator TP2 sowie dem Summierer S gestartet, wobei f2 das Ausgangssignal des Summierers S zeigt. Die Aktiverungsschwelle |(akt) von 3 Digit entspricht dabei bspw. 12 Grad Neigung. Die Kurzzeitintegration beginnt dabei mit einem entsprechenden Anfangswert von 12 Digit.

Wird zum Zeitpunkt t2 von der Kurzzeitintegration am Ausgang des Summierers S die Auslöseschwelle von 40 Digit erreicht, bspw. 40 Grad Neigung entspricht, so erfolgt ein Auslösebefehl an bestimmte Insassenschutzeinrichtungen. Die Werte der Auslöseschwellen sind dabei nur beispielhaft gewählt. Der Kippwinkel eines Kraftfahrzeugs liegt üblicherweise noch über 40 Grad.

Der Auslösezeitpunkt t2 kann dabei aufgrund der deutlich feineren Auflösung der Kurzzeitintegration präziser bestimmt werden als am Langzeitintegrator TP1, der bereits zuvor die 10-Digit-Schwelle überschritten hat.

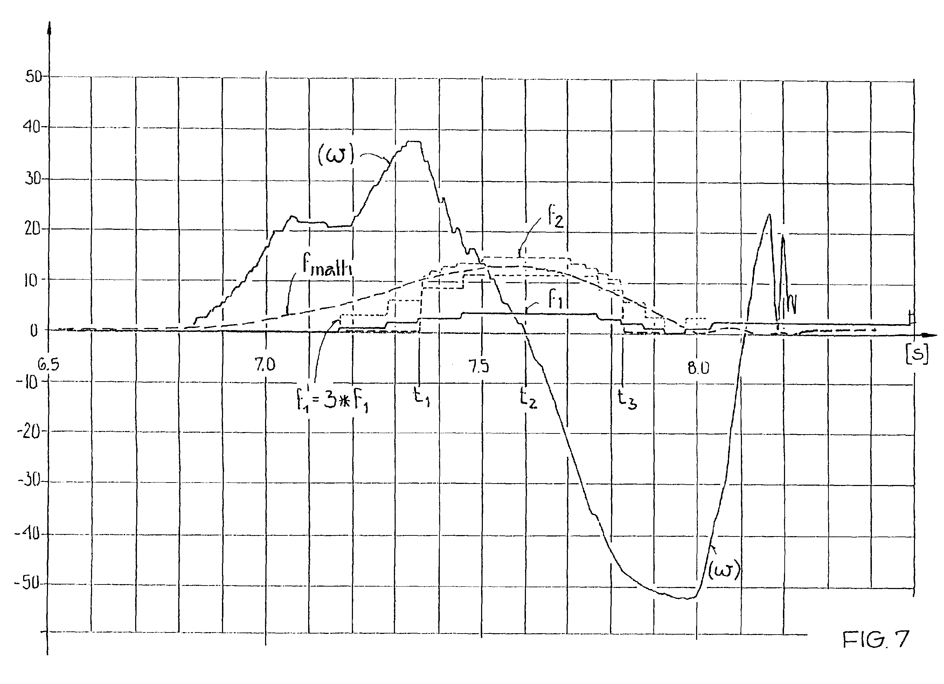

Figur 7 zeigt analog dazu einen Nicht-Auslösefall, der üblicherweise simuliert wird, indem ein Fahrzeug einseitig über eine Rampe gefahren wird. Wieder sind der Integralwert f1 am Langzeitintegrator TP1 in seiner gegebenen Größe sowie in f1' näherungsweise verstärkt auf f2 dargestellt. Zudem ist neben dem Integralwert f2 der Kurzzeitintegration auch das Drehgeschwindigkeitssignal ω dargestellt, welches am Eingang beider Tiefpässe TP1 und TP2 in diesem Beispiel anliegt.

Zum Zeitpunkt t1 wird die Aktivierungsschwelle am Langzeitintegrator TP1 überschritten und die Kurzzeitintegration mit dem entsprechenden Anfangswert gestartet. Zum Zeitpunkt t2 des Nulldurchgangs der Drehgeschwindigkeit w haben beide Tiefpässe ihr Maximum erreicht und integrieren vorzeichenrichtig nun die negativen Anteile weiter auf, was zu einem Absinken der Funktionen f1 und f2 führt. Dies ist jedoch von der bereits eingangs beschriebenen Rückführungsfunktion der Tiefpässe zu unterscheiden, die in den in Figur 7 vorliegenden Zeiträumen kaum merkbar ist. Die Rückführungsfunktion würde auch nur beim Langzeitintegrator TP1 auftreten, nicht bei der Kurzzeitintegration über TP1 und dem Summierer S. In Figur 7 wirkt sich nur der negative Verlauf des Eingangssignals ω aus. Als Abschaltkriterium wird in diesem Beispiel der Langzeitintegrator TP1 genutzt und die Abschaltschwelle identisch zur Aktivierungsschwelle gelegt. Zum Zeitpunkt t3 wird diese von f1 unterschritten und somit die Kurzzeitintegration f2 zurückgesetzt. Dadurch wird sichergestellt, daß die Offset-empfindliche Kurzzeitintegration nicht über eine Mehrzahl von Meßabläufen zu stark von den realen Werten abweicht.

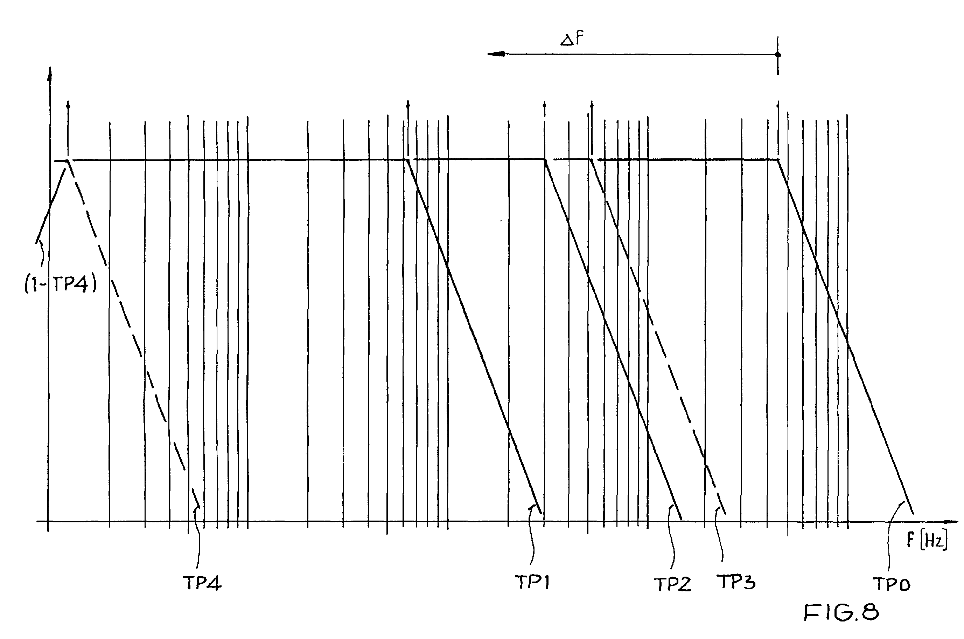

Figur 8 zeigt in logarithmischer Darstellung beispielhaft den Amplitudenfrequenzgang der einzelnen Filter im Vergleich übereinandergelegt. Entscheidend ist dabei zunächst die im Vergleich zu der des Langzeitintegrators TP1 höhere Grenzfrequenz des Kurzzeitintegrators TP2. So ist die Grenzfrequenz von TP2 vorzugsweise mindestens um den Faktor 5 größer als die Grenzfrequenz von TP1.

Dies bedeutet für ein Signal innerhalb des genutzten Frequenzbandes Δf, daß der Kurzzeitintegrator TP2 aufgrund der geringeren Dämpfung eine besssere Signalauflösung bei der Integration aufweist.

Für die Anwendung im Bereich der Überschlagserkennung sind die Grenzfrequenzen beider Tiefpässe kleiner 1 Hertz. Der Langzeitintegrator TP1 ist dabei während des Fahrtbetriebs des Fahrzeuges permanent aktiv und wird nur mit dem Abschalten der Zündung wieder zurückgesetzt. Die zu erwartenden Signale können dabei bis über eine Sekunde dauern, so daß der Langzeitintegrator TP1 einen dementsprechend großen Meßzeitbereich erfassen muß.

Der Kurzzeitintegrator TP2 wird hingegen im Bereich unter einer Sekunde, bspw. alle 200 msec. zurückgesetzt und neu gestartet, so daß auch für sich der Grenzfrequenz annähernde Signale die Nichtlinearität der Kennlinie keine entscheidenden Auswirkungen hat. Selbst wenn langsame Signale durch die Nichtlinearität verzerrt werden, so überwiegt doch der Vorteil durch die besssere Signalauflösung. Die Wahl der Grenzfrequenzen kann dabei an die speziellen Erfordernisse angepaßt werden. Dabei sind bei der Umsetzung in digitale Filter oder entsprechende Software die Verwendung möglichst nur eines Systemtakts zu berücksichtigen, so daß sich die Dauer des Zeitfensters und die zur Erzeugung der Filterwirkung wichtige Verzögerung aufeinanderfolgender Abtastwerte als ganzzahlige, möglichst sogar binäre Vielfache ergeben. Entsprechend werden auch die Filterfaktoren angepaßt.

## Patentansprüche

1. Verfahren zur Integration eines elektrischen Signals (s0) mittels Tiefpaßfilterung in einem vorgegebenen Meßzeitbereich, indem
a) parallel zu einem erster Tiefpaß (TP1) mit einer ersten Grenzfrequenz (fg1) ein zweiter Tiefpaß (TP2) mit einer höheren Grenzfrequenz (fg2>fg1) vorgesehen wird,
b) der zweite Tiefpaß (TP2) dann aktiviert wird, wenn das Ausgangssignal (s1) am ersten Tiefpaß (TP1) eine vorgegebene Aktivierungsschwelle (α(akt)) überschreitet,
c) der zweite Tiefpaß (TP2) das elektrische Signal (s0) über ein gegenüber dem Meßzeitbereich kurzes Zeitfenster (T) zu einem Kurzzeitintegrationswert (Δα) integriert und an einen Summierer (S) übergibt,
d) wobei zum Ende des Zeitfensters (T(1)) der zweite Tiefpaß (TP2) zurückgesetzt und die Kurzzeitintegration gemäß Schritt c) für weitere Zeitfenster (T(2), T(3)...) jeweils neu gestartet wird und
e) im Summierer (S) die Kurzzeitintegrationswerte (Δα) aller aufeinanderfolgenden Zeitfenster (T) zu einem Integrationswert (α=ΣΔα | über alle T) addiert werden, bis ein Abschaltkriterium erreicht wird.

2. Verfahren nach Anspruch 1, dadurch gekennzeichnet, daß als Abschaltkriterium die Unterschreitung einer Abschaltschwelle durch das Ausgangssignal (s1) am ersten Tiefpaß (TP1) verwendet wird.

3. Verfahren nach Anspruch 1 oder 2, dadurch gekennzeichnet, daß beim erstmaligen Start der Kurzzeitintegration (t1) ein Anfangswert (α0) gesetzt wird, welcher der Aktivierungsschwelle (a(akt)) am ersten Tiefpaß (TP1) entspricht.

4. Verfahren nach einem der vorangehenden Ansprüche, dadurch gekennzeichnet, daß die Integralwerte des Summierers (S) und des ersten Tiefpasses (TP1) auf zumindest näherungsweise Übereinstimmung miteinander verglichen werden (s1 ≈ s5 ?), wobei zumindest einer der beiden Integralwerte (sl,s5) durch einen Faktor gewichtet wird.

5. Verfahren nach einem der vorangehenden Ansprüche, dadurch gekennzeichnet, daß für den ersten und zweiten Tiefpaß (TP1,TP2) eine Offset-Kompensation erfolgt, indem das Signal einem Offset-Kompensations-Tiefpaß (TP4) mit einer Grenzfrequenz unterhalb der Grenzfrequenzen beider Tiefpässe (TP1 ,TP2) zugeführt und das Ausgangssignal (s4) dieses Offset-Kompensations-Tiefpasses (TP4) von den Eingangs- oder Ausgangssignalen der beiden Tiefpässe (TP1,TP2) abgezogen wird.

6. Verfahren nach Anspruch 5, dadurch gekennzeichnet, daß die Offset-Kompensation zumindest für den zweiten Tiefpaß (TP2) zur Kurzzeitintegration bereits an dessen Eingang erfolgt.

7. Verfahren nach einem der vorangehenden Ansprüche, dadurch gekennzeichnet, daß ausgehend von einer unteren und einer oberen Nutzsignalgrenzfrequenz des elektrischen Signals die Grenzfrequenzen des ersten und zweiten Tiefpasses bestimmt werden, indem
a) die Grenzfrequenz des ersten Tiefpasses soweit unterhalb der unteren Nutzsignalgrenzfrequenz liegt, daß für diese untere Nutzsignalgrenzfrequenz über den Meßzeitbereich eine annähernd lineare Integration im ersten Tiefpaß erfolgt und
b) die Grenzfrequenz des zweiten Tiefpasses soweit unterhalb der oberen Nutzsignalgrenzfrequenz liegt, daß für diese obere Nutzsignalgrenzfrequenz über das Zeitfenster eine annähernd lineare Integration im zweiten Tiefpaß erfolgt.

8. Verwendung des Verfahrens zur Erzeugung eines Geschwindigkeitssignals durch Integration eines von einem Sensor erfaßten Beschleunigungsverlaufs.

9. Verwendung des Verfahrens zur Erzeugung eines Verdrehwinkelsignals (α) durch Integration eines von einem Sensor erfaßten Winkelgeschwindigkeitsverlaufs (ω).
